# DEMANDE DE BREVET EUROPEEN

(11) **EP 4 095 889 A1**
(43) Date de publication de la demande: **30.11.2022**
(21) Numéro de dépôt: 22175459.1
(22) Date de dépôt: 25.05.2022
(51) Int. Cl.: H01L 21/336, H01L 29/775, H01L 29/423, H01L 29/06, B82Y 10/00, H01L 29/08, H01L 29/10, H01L 29/161, H01L 21/02, H01L 29/78, H01L 29/786

(54) **PROCÉDÉ DE FABRICATION D'UN TRANSISTOR A STRUCTURE DE GRILLE ENROBANTE**

(30) Priorité: 27.05.2021 FR 2105519
(71) Demandeur: Commissariat à l'énergie atomique et aux énergies alternatives, 75015 Paris (FR)
(72) Inventeur: LE ROYER, Cyrille, 38054 GRENOBLE CEDEX 09 (FR); KANYANDEKWE, Joël, 38054 GRENOBLE CEDEX 09 (FR); BARRAUD, Sylvain, 38054 GRENOBLE CEDEX 09 (FR)
(74) Mandataire: Cabinet Camus Lebkiri

(57) **Abrégé**

L'invention concerne un procédé de fabrication d'un transistor pFET, le procédé de fabrication du transistor comprenant les étapes suivantes :
- la fourniture d'une structure de base comprenant un canal (31, 32) en silicium et une structure de grille (2), la structure de grille enrobant le canal en laissant libre deux flancs du canal (3a) ;
- la croissance d'une première couche (10) en alliage de silicium-germanium sur les flancs du canal ;
- l'enrichissement du canal (3) avec des atomes de germanium de la première couche ; et
- la formation d'une région de drain et d'une région de source de part et d'autre du canal.

## Description

### DOMAINE TECHNIQUE DE L'INVENTION

Le domaine technique de l'invention est celui des transistors de type à effet de champ, dit transistor FET pour "field effect transistor" en anglais, comprenant un canal en matériau semiconducteur enrobée par une structure de grille. Il s'agit par exemple de transistors FET dit à grille tout autour, également appelés GAAFET pour "gate all around field-effect transistor" en anglais, et de transistors FET dit à ailettes, également appelés FinFET pour "fin field-effect transistor" en anglais. Le domaine de l'invention concerne plus particulièrement la fabrication d'un transistor de ce type.

### ARRIÈRE-PLAN TECHNOLOGIQUE DE L'INVENTION

Un transistor FET, comprend un canal en matériau semiconducteur disposée entre une région de drain et une région de source. La conductivité des portions semiconductrices formant le canal est influencée par une grille localisée à proximité de chaque portion. Afin d'améliorer l'efficacité des transistors FET et réduire leur encombrement, la grille est avantageusement disposée sur plusieurs côtés du canal de manière à améliorer l'influence électrostatique de la grille sur chaque portions semiconductrice. Par exemple, une architecture de transistor FinFET comprend un canal comprenant au moins une ailette semiconductrice, orientée verticalement par rapport au substrat et dont chaque côté est en contact avec la grille. L'influence électrostatique de la grille sur le canal peut être encore améliorée lorsque cette dernière enrobe totalement chaque portions semiconductrices. Une architecture de transistor GAAFET comprend canal comprenant au moins une portion semiconductrice en forme de nano-fil ou de nano-feuille dont une partie est entièrement enrobée par la grille.

La demande de brevet FR 3043837 A1 divulgue un procédé de fabrication d'un transistor GAAFET, comprenant plusieurs nano-fils semiconducteurs enrobés par une grille. Le procédé de fabrication comprend la formation d'un empilement de couches semiconductrices alternant, à partir d'un substrat, une première couche semiconductrice et une deuxième couche semiconductrice. Les nano-fils destinés à former le canal sont réalisés dans chaque deuxième couche. Le procédé comprend notamment une gravure sélective de chaque première couche afin de permettre la formation de la grille de sorte qu'elle puisse enrober une portion de chaque nano-fil.

Un transistor GAAFET peut comprendre un canal en silicium-germanium, favorisant la mobilité de trous, ou un canal en silicium, favorisant la mobilité des électrons. Dans le premier cas, il s'agit alors d'un transistor dit pFET et dans le second cas d'un transistor dit nFET.

La réalisation d'un transistor pFET nécessite ainsi :
- la formation d'un empilement comprenant, à partir du substrat, une première couche en silicium et une deuxième couche en silicium-germanium ; et
- la gravure de chaque première couche en silicium sélectivement par rapport à chaque deuxième couche en silicium-germanium.

À l'inverse, la réalisation d'un transistor nFET nécessite :
- la formation d'un empilement comprenant, à partir du substrat, une première couche en silicium-germanium et une deuxième couche en silicium ; et
- la gravure de chaque première couche en silicium-germanium sélectivement par rapport à chaque deuxième couche en silicium.

Il est donc nécessaire, suivant le procédé de l'art antérieur, d'adapter les étapes de fabrication et les équipements mis en œuvre selon que l'on souhaite réaliser un transistor pFET ou un transistor nFET. Il est notamment nécessaire de mettre en œuvre deux recettes différentes pour réaliser les gravures spécifiques de chaque première couche selon que cette dernière soit en silicium ou en silicium-germanium.

Il existe donc un besoin de prévoir un procédé de fabrication d'un transistor pFET à canal silicium-germanium qui se rapproche davantage du procédé de fabrication d'un transistor nFET à canal silicium.

### RÉSUMÉ DE L'INVENTION

L'invention offre une solution aux problèmes évoqués précédemment, en permettant de former un transistor pFET à partir d'une structure de base commune à la fabrication d'un transistor nFET.

L'invention concerne un procédé de fabrication d'un transistor pFET, le procédé de fabrication du transistor comprenant les étapes suivantes :
- la fourniture d'une structure de base comprenant un canal en silicium et une structure de grille, la structure de grille enrobant le canal en laissant libre deux flancs du canal ;
- la croissance d'une première couche en alliage de silicium-germanium sur les flancs du canal ;
- l'enrichissement du canal avec des atomes de germanium de la première couche ; et
- la formation d'une région de drain et d'une région de source de part et d'autre du canal.

La structure de base permet de réaliser un transistor pFET ou un transistor nFET, selon que le canal en silicium soit enrichi ou non en germanium. Le procédé de fabrication d'un transistor pFET peut donc facilement être dérivé de celui d'un transistor nFET.

L'enrichissement du canal en silicium au moyen d'atomes de germanium confère de bonnes propriétés au transistor pFET. En effet, les atomes de germanium présentent une taille plus importante et applique une contrainte de déformation au réseau cristallin de silicium. Cette déformation a pour effet d'augmenter la mobilité des trous.

Outre les caractéristiques qui viennent d'être évoquées dans le paragraphe précédent, le procédé de fabrication selon l'invention peut présenter une ou plusieurs caractéristiques complémentaires parmi les suivantes, considérées individuellement ou selon toutes les combinaisons techniquement possibles :
- la structure de grille entoure complètement une portion du canal ;
- la structure de grille comprend une électrode de grille et un diélectrique de grille séparant l'électrode de grille du canal ;
- le diélectrique de grille présente une permittivité électrique relative supérieure ou égale à 20 ;
- la structure de grille comprend des espaceurs latéraux disposés de part et d'autre de la structure de grille, à l'aplomb de chaque flanc du canal ;
- le canal de la structure de base comprend une nano-feuille en silicium et préférentiellement une pluralité de nano-feuilles en silicium parallèles entre elles ;
- le canal de la structure de base comprend un nano-fil en silicium et préférentiellement une pluralité de nano-fils en silicium parallèles entre eux ;
- le canal de la structure de base comprend une ailette en silicium et préférentiellement une pluralité d'ailettes en silicium parallèles entre elles ;
- le canal de la structure de base comprend au moins une nano-feuille en silicium ou au moins un nano-fil en silicium ou au moins une ailette en silicium, préférentiellement une pluralité de nano-feuilles en silicium empilées ou une pluralité de nano-fils en silicium empilés ou une pluralité d'ailettes en silicium parallèles entre elles ;
- le canal de la structure de base comprend une pluralité d'ailettes en silicium parallèles entre elles et la structure de base comprend des plots en matériau diélectrique disposés de part et d'autre du canal entre chaque ailette en silicium ;
- le procédé de fabrication comprend le retrait des plots après l'enrichissement du canal ;
- la croissance de la première couche en alliage de silicium-germanium est amorcée à partir des flancs de chaque nano-feuille en silicium ou à partir des flancs de chaque nano-fil en silicium ou à partir des flancs de chaque ailette en silicium ;
- l'enrichissement est configuré pour transformer le silicium du canal en alliage de silicium-germanium ;
- l'enrichissement est réalisé par application d'un recuit de diffusion configuré pour faire diffuser des atomes de germanium de la première couche dans le canal ;
- l'enrichissement est réalisé par oxydation de la première couche configurée pour faire condenser des atomes de germanium de la première couche dans le canal ;
- la condensation des atomes de germanium dans le canal est provoquée par l'oxydation de la première couche, préférentiellement complétée par l'application d'un recuit ;
- la formation des régions de drain et de source est réalisée par la formation d'une deuxième couche sur la première couche de part et d'autre du canal, la formation de la deuxième couche étant configurée pour appliquer une contrainte de compression sur le canal ;
- la formation de la deuxième couche est configurée pour appliquer une contrainte de compression sur le canal ;
- la deuxième couche est formée par épitaxie ;
- la fourniture de la structure de base comprend : la formation, sur un substrat, d'une zone active, d'une grille sacrificielle sur une portion de la zone active et de premiers espaceurs latéraux de part et d'autre de la grille sacrificielle ; la délimitation du canal à partir de la zone active en formant les flancs libres du canal à l'aplomb des premiers espaceurs latéraux (6) ; et la formation de la structure de grille en remplacement de la grille sacrificielle ;
- la formation de la zone active comprend la formation d'un empilement et la délimitation de la zone active à partir de l'empilement ;
- la zone active comprend une couche en silicium ;
- la zone active comprend un empilement de couches comprenant au moins une couche de silicium-germanium et au moins une couche de silicium en alternance, l'empilement de couches commençant, à partir du substrat, par une couche de silicium-germanium ;
- la formation de la structure de grille comprend un remplacement de ladite au moins une couche de silicium-germanium par un diélectrique de grille et une électrode de grille
- la structure de grille remplace en outre ladite au moins une couche de silicium-germanium.

L'invention concerne en outre un procédé de fabrication d'une pluralité de transistors pFET, chaque transistor pFET étant obtenu par la mise en œuvre du procédé de fabrication d'un transistor pFET selon l'invention.

Outre les caractéristiques qui viennent d'être évoquées dans le paragraphe précédent, le procédé de fabrication d'une pluralité de transistors pFET selon l'invention peut présenter une ou plusieurs caractéristiques complémentaires parmi les suivantes, considérées individuellement ou selon toutes les combinaisons techniquement possibles :
- les transistors pFET sont fabriqués simultanément ;
- l'enrichissement des régions de canal par oxydation est choisi lorsque l'épaisseur de chaque première couche est inférieure à la moitié d'une distance séparant les structures de grille de deux structures de base consécutives ;
- l'enrichissement des régions de canal par application d'un recuit est choisi lorsque l'épaisseur de chaque première couche est supérieure ou égale à la moitié d'une distance séparant les structures de grille de deux structures de base consécutives.

La réalisation de transistors pFET et nFET sur un même substrat, dit cointégration, selon les procédés de l'art antérieur, nécessite de réaliser des étapes de fabrication spécifiques sur des premières structures destinées à former un transistor pFET ou sur des deuxièmes structures destinées à former un transistor nFET. Il est ainsi nécessaire de protéger à plusieurs reprises les premières structures lorsque l'étape de fabrication concerne les deuxièmes structures et inversement. Le procédé de fabrication comprend ainsi plusieurs étapes de protection/libération des premières ou deuxièmes structures. Il existe donc un besoin d'améliorer le procédé de cointégration des transistors pFET et nFET.

L'invention offre une solution à la cointégration de transistors pFET et nFET sur un même substrat en permettant la fourniture d'une même structure de base.

Ainsi, l'invention concerne également un procédé de cointégration d'un premier transistor pFET et un deuxième transistor nFET, le procédé de cointégration comprenant les étapes suivantes :
- la fourniture d'une première structure de base et d'une deuxième structure de base identique à la première structure de base, chaque structure de base comprenant un canal en silicium et une structure de grille, la structure de grille enrobant le canal en laissant libre deux flancs du canal ;
- sur la première structure de base : la croissance d'une première couche en alliage de silicium-germanium sur les flancs du canal ; l'enrichissement du canal avec des atomes de germanium de la première couche ; la formation d'une première région de drain et d'une première région de source de part d'autre du canal ; et
- sur la deuxième structure de base, la formation d'une deuxième région de drain et d'une deuxième région de source de part d'autre du canal.

La structure de base comprend un canal complet, qu'il suffit d'enrichir ou non selon le type de transistor souhaité, et une structure de grille définitive. Les étapes de protection/libération sélectives lors de la fourniture des premières et deuxièmes structures de base sont donc supprimées. Le procédé de cointégration est donc amélioré car simplifié.

Outre les caractéristiques qui viennent d'être évoquées dans le paragraphe précédent, le procédé de cointégration selon l'invention peut présenter une ou plusieurs caractéristiques complémentaires parmi les suivantes, considérées individuellement ou selon toutes les combinaisons techniquement possibles :
- le procédé de cointégration comprend, avant l'étape de croissance appliquée à la première structure de base, la protection de la deuxième structure de base au moyen d'une première couche protectrice ;
- le procédé de cointégration comprend, avant l'étape de formation appliquée à la deuxième structure de base, la libération de la deuxième structure de base en retirant la première couche protectrice ;
- le procédé de cointégration comprend, avant l'étape de formation appliquée à la deuxième structure de base, la protection du premier transistor pFET au moyen d'une deuxième couche protectrice.

### BRÈVE DESCRIPTION DES FIGURES

L'invention et ses différentes applications seront mieux comprises à la lecture de la description qui suit et à l'examen des figures qui l'accompagnent.

Les figures sont présentées à titre indicatif et nullement limitatif de l'invention.
[Fig. 1] représente un logigramme d'un procédé de fabrication de transistor pFET selon l'invention.
[Fig. 2a], [Fig. 2b], [Fig. 3], [Fig. 4], [Fig. 5], [Fig. 6], [Fig. 7] et [Fig. 8] représentent schématiquement des étapes du procédé de fabrication de la [Fig. 1].
[Fig. 9] représente un premier logigramme d'une étape de fourniture d'une structure de base selon l'invention.
[Fig. 10], [Fig. 11a], [Fig. 11b], [Fig. 11c], [Fig. 12], [Fig. 13a], [Fig. 13b], [Fig. 13c], [Fig. 14], [Fig. 15], [Fig. 16], [Fig. 17], [Fig. 18], [Fig. 19] et [Fig. 20] représentent schématiquement des sous-étapes de l'étape de fourniture de la [Fig. 9].
[Fig. 21a], [Fig. 21b], [Fig. 22], [Fig. 23], [Fig. 24], [Fig. 25a], [Fig. 25b], [Fig. 25c], [Fig. 25d], [Fig. 26a], [Fig. 26b], [Fig. 27] et [Fig. 28] représentent schématiquement des étapes de fabrication du procédé de la [Fig. 1].
[Fig. 29] représente un deuxième logigramme d'une étape de fourniture selon l'invention.
[Fig. 30], [Fig. 31a], [Fig. 31b], [Fig. 32], [Fig. 33a], [Fig. 33b], [Fig. 34], [Fig. 35], [Fig. 36], [Fig. 37], [Fig. 38], [Fig. 39], [Fig. 40] et [Fig. 41] représentent schématiquement des sous-étapes de l'étape de fourniture de la [Fig. 29].
[Fig. 42] représente un logigramme d'un procédé de cointégration selon l'invention.
[Fig. 43a], [Fig. 43b], [Fig. 44], [Fig. 45], [Fig. 46], [Fig. 47], [Fig. 48], [Fig. 49], [Fig. 50] et [Fig. 51] représentent schématiquement des étapes du procédé de la [Fig. 42].
Sauf précision contraire, un même élément apparaissant sur des figures différentes présente une référence unique. Les figures sont présentées à titre indicatif et nullement limitatif de l'invention.

### DESCRIPTION DÉTAILLÉE

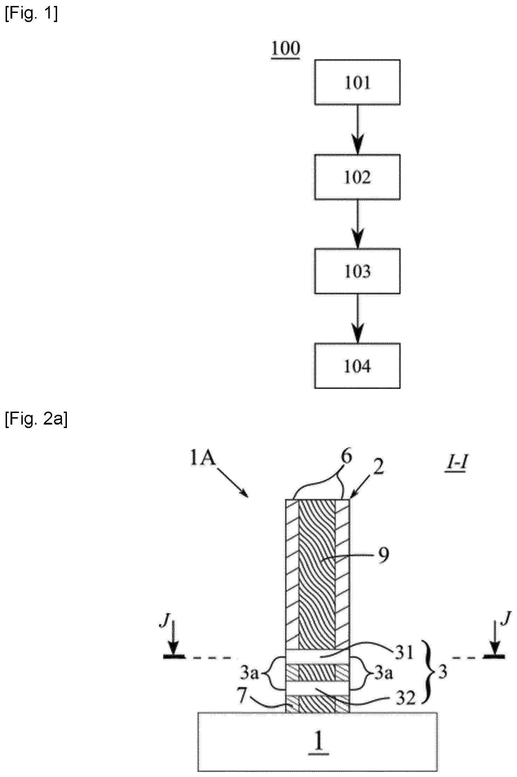

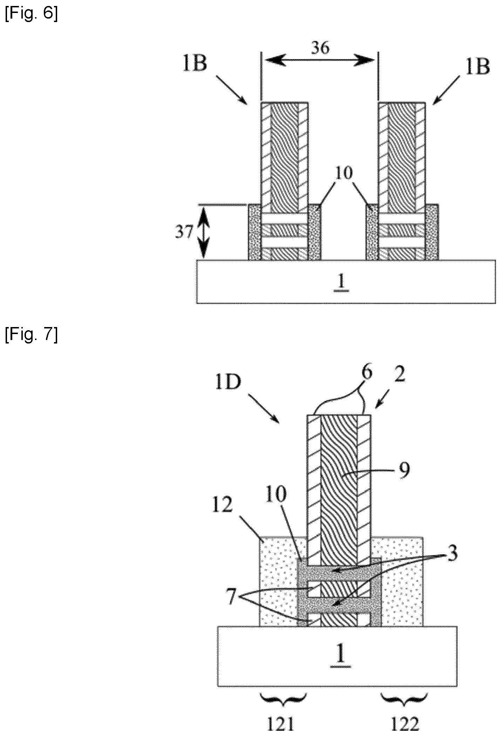

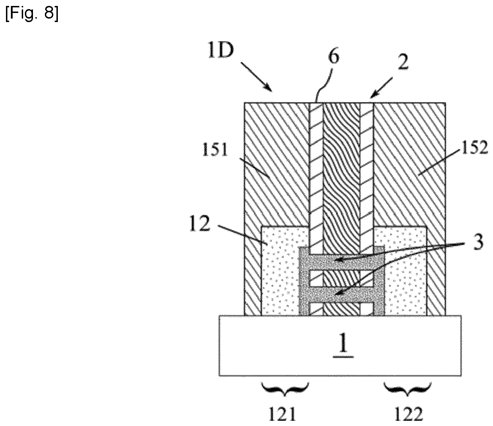

La [Fig. 1] représente un logigramme correspondant à un mode de mise en œuvre d'un procédé de fabrication d'un transistor pFET. Le transistor obtenu 1D est représenté schématiquement par les [Fig. 7] et [Fig. 8]. Une structure de base 1A et des structures intermédiaires 1B, 1C obtenues à l'issue de chacune des étapes du procédé de fabrication 100 sont représentées schématiquement par les [Fig. 2a] à [Fig. 6].

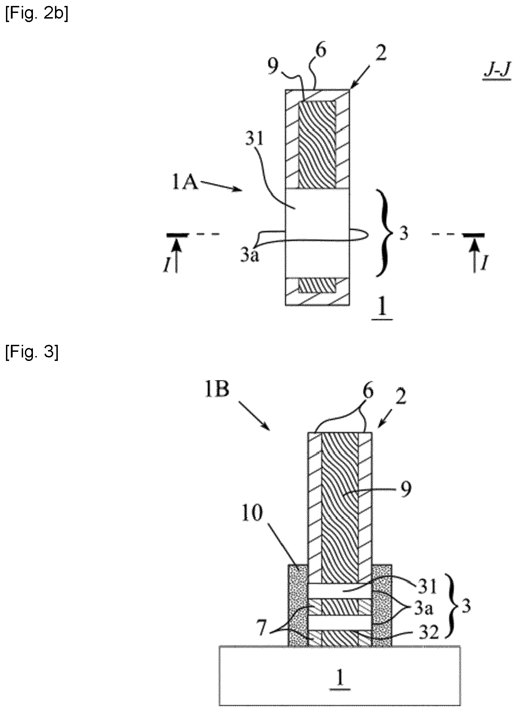

Une première étape 101 du procédé de fabrication 100 comprend la fourniture d'une structure de base 1A, à partir de laquelle sera réalisé le transistor pFET. Les [Fig. 2a] et [Fig. 2b] représentent schématiquement la structure de base 1A selon un premier mode de réalisation. La [Fig. 2a] représente une vue en coupe de la structure de base 1A selon un plan /-/ matérialisé dans la [Fig. 2b]. La [Fig. 2b] représente une vue de dessus de la structure de base 1A selon un plan J-J matérialisé dans la [Fig. 2a].

La structure de base 1A est disposée sur un substrat 1. Elle comprend un canal 3 enrobé par une structure de grille 2. Le canal 3 peut avantageusement comprendre une ou plusieurs couches semiconductrices formant des canaux de conduction du transistor pFET. Dans l'exemple de réalisation de la [Fig. 2a], le canal 3 comprend deux couches semiconductrices 31, 32 parallèles au substrat 1. Chacune des couches semiconductrices 31, 32 est enrobée par la structure de grille 2. Les deux couches semiconductrices 31, 32 peuvent être superposée l'une sur l'autre. Les deux couches semiconductrices 31, 32 peuvent également être appelée nano-feuille. Par nano-feuille, on entend une couche s'étendant dans un plan parallèle à la surface du substrat et présentant préférentiellement une épaisseur inférieure à 20 nm, l'épaisseur étant mesurée perpendiculairement par rapport à la surface du substrat 1.

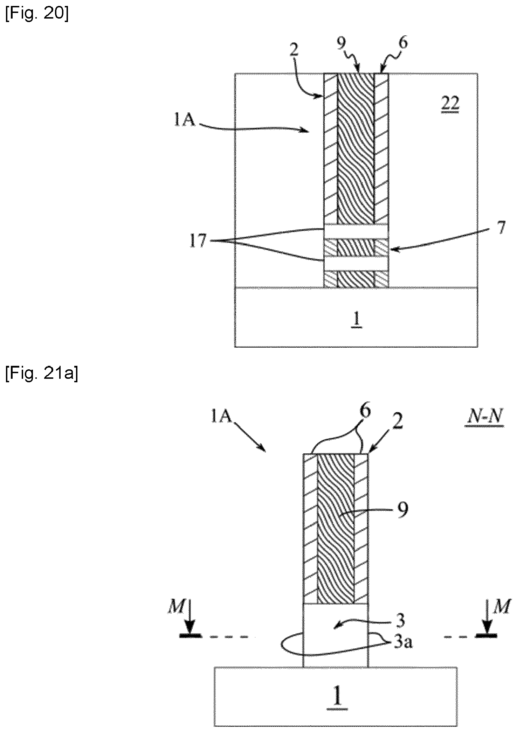

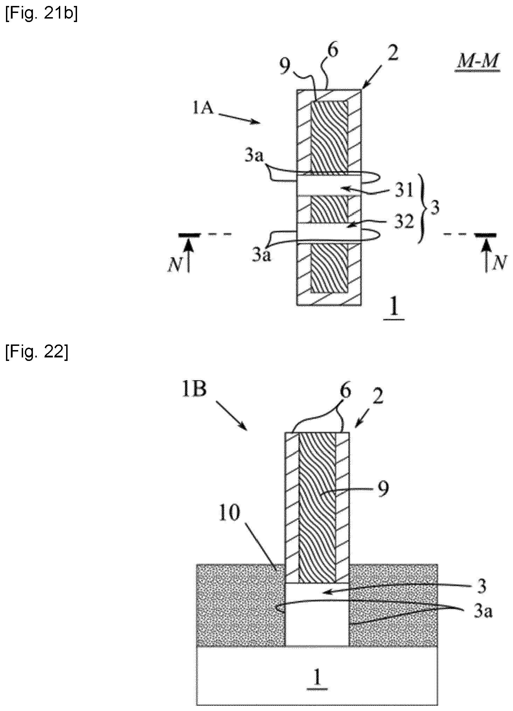

Un autre exemple de structure de base 1A, présentant des couches semiconductrices orientées verticalement par rapport à la surface du substrat 1, sera décrit ultérieurement en référence aux [Fig. 21a] et [Fig. 21b].

Le substrat 1 peut être en silicium massif ou de type silicium sur isolant, dit SOI pour "Silicium On Insulator" en anglais. Dans ce dernier cas, il comprend une couche isolante enterrée sous une fine couche de silicium non dopée. Le substrat 1 peut être, de manière encore préférée, de type silicium sur isolant complétement déplété (ou FDSOI pour "Fully Depleted Silicon on Insulator" en anglais) afin d'améliorer les caractéristiques électroniques du transistor final.

Chaque nano-feuille 31, 32 du canal 3 présente deux extrémités opposées, destinées à être contactées par des régions de drain et de source. Les deux extrémités de chaque nano-feuille forment des surfaces libres appartenant aux flancs 3a du canal 3. La structure de base 1A des [Fig. 2a] et [Fig. 2b] permet de réaliser un transistor à grille tout autour, dit de type GAAFET.

La structure de base 1A est remarquable en ce que chacune des nano-feuilles semiconductrices 31, 32 du canal 3 est en silicium. La structure de base 1A peut donc également être mise en œuvre dans un procédé de fabrication d'un transistor nFET (le canal d'un transistor nFET étant en silicium).

La structure de grille 2 comprend une électrode de grille 9, un oxyde de grille (non représenté) disposé entre le canal 3 et l'électrode de grille 9, et des premiers et deuxièmes espaceurs latéraux 6, 7. L'électrode de grille 9 est destinée à appliquer un potentiel électrostatique sur le canal 3 et est préférentiellement positionnée tout autour (" gate-all around " en anglais) d'une portion centrale du canal 3. Les premiers et deuxièmes espaceurs latéraux 6, 7 sont disposés de part et d'autre de l'électrode de grille 9 et réalisent une isolation électrique entre l'électrode de grille 9 et les futures régions de source et de drain. Les premiers et deuxièmes espaceurs latéraux 6, 7 sont préférentiellement disposés, à l'aplomb des extrémités de chaque couche 31, 32 du canal 3. De cette manière, la structure de grille 2 enrobe le canal 3 en laissant les flancs 3a du canal 3 apparents. Les flancs 3a peuvent également être appelés parois latérales.

La [Fig. 3] représente une première structure intermédiaire 1B obtenue à l'issue d'une deuxième étape 102 du procédé de fabrication 100. Cette deuxième étape 102 comprend la croissance d'une première couche 10 en alliage de silicium-germanium sur les flancs 3a du canal 3 de la structure de base 1A. La première couche 10 peut également être appelée couche réservoir. La couche réservoir 10 est disposée de part et d'autre de la structure de grille 2, au contact de chaque flanc 3a du canal 3. La couche réservoir 10 est par exemple réalisée par épitaxie à partir des extrémités libres de chaque nano-feuille semiconductrice 31, 32, c'est à dire au niveau de chaque flanc 3a. L'épitaxie est ainsi amorcée à partir des couches en silicium du canal 3. La couche réservoir 10 est en alliage de silicium-germanium et peut être dopé ou intrinsèque.

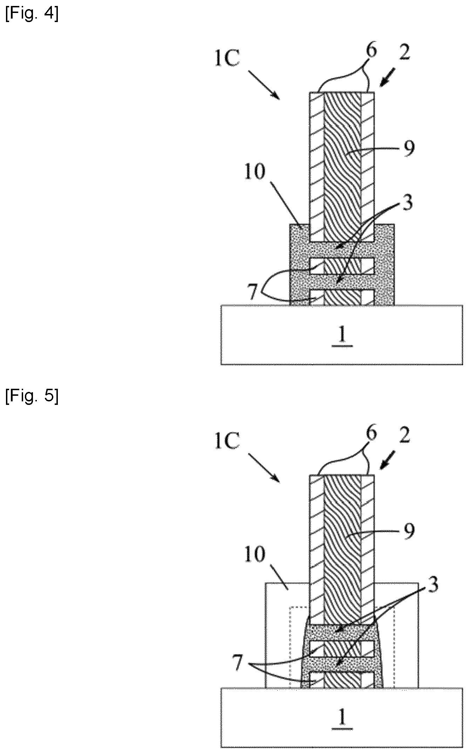

La [Fig. 4] représente une deuxième structure intermédiaire 1C obtenue à l'issue d'un enrichissement 103 du canal 3 avec des atomes de germanium de la couche réservoir 10. L'enrichissement 103 est avantageusement configuré pour transformer le silicium du canal 3, c'est à dire des nano-feuilles 31, 32, en alliage de silicium-germanium. Ainsi, le canal 3 obtenu correspond à un canal d'un transistor de type pFET.

L'enrichissement 103 du canal au moyen d'atomes de germanium permet d'améliorer la mobilité des porteurs de charges du transistor pFET, en l'occurrence des trous. En effet, les atomes de germanium présentent un diamètre, et donc un paramètre de maille, plus important que les atomes de silicium. Leur intégration dans le réseau cristallin impose donc une contrainte de déformation du réseau de silicium, ayant pour effet une amélioration de la mobilité des trous. Cet effet peut être particulièrement avantageux lorsque l'étape de fourniture 101 de la structure de base 1A tend à relâcher la contrainte initiale des nano-feuilles de silicium, notamment lors de la formation des deuxièmes espaceurs 7. Ainsi, l'étape d'enrichissement 103 permet de remettre les canaux sous contrainte et donc de retrouver, voire dépasser, la mobilité initiale des trous. Afin d'améliorer significativement la mobilité de trous, la concentration d'atomes de germanium dans l'alliage de silicium-germanium est avantageusement supérieure à 20 % de l'alliage (et donc 80 % de silicium). Plus la concentration en atomes de germanium dans l'alliage de silicium-germanium est élevée et meilleure est la mobilité des trous. Afin de bénéficier d'une amélioration de la mobilité des trous ainsi que de l'effet de la contrainte de déformation provoquée par les atomes de germanium, la concentration d'atomes de germanium dans l'alliage de silicium-germanium est avantageusement supérieure ou égale à 30 % de l'alliage.

L'enrichissement 103 peut être réalisé de deux manières différentes. Selon un premier mode de mise en œuvre, l'enrichissement 103 est réalisé par l'application d'un recuit de diffusion sur la première structure intermédiaire 1B, et notamment au niveau de la première couche 10 et du canal 3. Le recuit de diffusion entraîne la diffusion des atomes de germanium à partir d'une zone riche en germanium, c'est à dire la couche réservoir 10, vers une zone pauvre en germanium, c'est à dire le canal 3 et plus particulièrement les nano-feuilles 31, 32. Le recuit de diffusion peut être réalisé à une température supérieure ou égale à 900 °C sous une atmosphère inerte et préférentiellement 1000 °C, voire 1050 °C. De la sorte, la diffusion du germanium au sein du canal 3 est efficace. Il convient toutefois de réaliser un recuit ne dégradant pas l'état de la structure de grille 2, notamment lorsque celle-ci comprend du tungstène. Pour cela, la durée du recuit dépend par exemple du budget thermique de la structure de grille 2. La durée du recuit est préférentiellement inférieure à 1 min.

Selon un deuxième mode de mise en œuvre, illustré par la [Fig. 5], l'enrichissement 103 est réalisé par condensation du germanium dans le canal 3. La condensation est réalisée par oxydation de la couche réservoir 10. L'oxyde de silicium formé pousse les atomes de germanium vers le canal 3 et plus particulièrement les nano-feuilles 31, 32. L'oxydation de la couche réservoir 10 est préférentiellement réalisée sous atmosphère oxydante. Un recuit peut également être appliqué à température supérieure à 1000 °C pendant une minute afin de provoquer le déplacement des atomes de germanium et faciliter l'enrichissement 103 et l'homogénéiser la concentration en germanium dans la couche finale.

L'enrichissement 103 par diffusion nécessite un gradient de concentration importante entre la zone riche en germanium et la zone à enrichir. Une forte concentration en germanium de la couche réservoir 10 est donc nécessaire pour enrichir efficacement le canal 3. La concentration en germanium de la couche réservoir 10 est par exemple supérieure à 30 %, concentration à partir de laquelle l'énergie d'activation pour permettre le déplacement des atomes de germanium est fortement réduite.

En revanche, l'enrichissement 103 par condensation présente le désavantage de favoriser la croissance d'une couche d'oxyde sur la couche réservoir 10, l'ensemble occupant un volume final plus important que lorsque l'enrichissement 103 est réalisé par diffusion. La couche d'oxyde est préférentiellement retirée avant de réaliser les régions de drain et de source.

L'enrichissement 103 par oxydation peut être favorisé lorsqu'un espacement au voisinage de la première structure intermédiaire 1B permet d'accueillir l'augmentation de volume de la couche réservoir 10. Le volume final dépend du volume initial de la couche réservoir 10 qui est sensiblement proportionnel à l'épaisseur de ladite couche réservoir 10. La [Fig. 6] représente l'épaisseur 37 de la couche réservoir 10 mesurée perpendiculairement au substrat 1

Lorsqu'une pluralité de transistor sont réalisés sur un même substrat, on peut définir une période de grille en réseau correspondant à la période spatiale des transistors finaux. La période de grille en réseau dépend notamment de d'une distance 36 séparant les structures de grille de structures de base 1A consécutives ou séparant les structures de grille 2 de premières structures intermédiaires 1B consécutives. Lorsque la distance 36 séparant les structures de grille 2 consécutives est supérieure à deux fois l'épaisseur 37 de la couche réservoir 10, alors l'espacement entre les deux deuxièmes structures intermédiaires 1B est considéré comme suffisant pour réaliser un enrichissement 103 par oxydation de la couche réservoir 10. En revanche, lorsque la distance 36 séparant les structures de grille 2 consécutives est inférieure à ou égale à deux fois l'épaisseur 17 de la couche réservoir 10, alors l'espacement entre les deux deuxièmes structures intermédiaires 1B est considéré comme insuffisant pour réaliser un enrichissement 103 par oxydation et l'application d'un recuit de diffusion est préféré.

La [Fig. 7] représente une troisième structure intermédiaire 1D obtenue à l'issue de la quatrième étape 104 du procédé de fabrication 100. La quatrième étape 104 comprend la formation d'une région de drain 121 et d'une région de source 122 de part d'autre du canal 3. La structure intermédiaire 1D ainsi obtenue correspond à un transistor pFET. La formation des régions de drain et de source 121, 122 est réalisée par épitaxie d'une couche 12 en silicium germanium (SiGe) dopée de type p sur la première couche 10, de part et d'autre de la structure de grille 2. La couche 12 en SiGe dopé est par exemple dopée au bore. Afin d'améliorer la qualité de l'interface entre la couche réservoir 10 et la couche en SiGe dopé 12, la couche en SiGe dopé est réalisée par épitaxie à partir de la couche réservoir 10. De la sorte, la structure cristalline du canal et de la couche réservoir 10 est conservée et transférée dans toutes les régions de drain et de source 121, 122, améliorant les propriétés du transistor.

La croissance de la couche 12 en SiGe dopé par épitaxie est préférentiellement réalisée sur les flancs préférentiellement verticaux de la première couche 10, afin d'appliquer une contrainte de compression sur les flancs 3a du canal 3 et améliorer davantage la mobilité des trous.

L'étape de formation des régions de drain et de source 121, 122 peut également comprendre, avant le dépôt de la couche 12 en SiGe dopé, une gravure partielle de la couche réservoir 10. La gravure partielle permet notamment de réduire la distance entre les flancs 3a du canal 3 et les régions de source et de drain 121, 122. La gravure partielle permet également de libérer un volume supplémentaire pour les régions de drain et de source 121, 122. La gravure partielle comprend le retrait de l'oxyde de surface de la première couche 10 ainsi qu'un traitement de surface au moyen d'un plasma.

La [Fig. 8] représente une structure finale de transistor issue d'une étape complémentaire de formation d'électrodes de drain et de source 151, 152 à partir des régions de drain et de source 121, 122. Les électrodes de drain et de source sont par exemple réalisées en tungstène.

Le procédé de fabrication 100 peut permettre de fabriquer une pluralité de transistors pFET simultanément. Pour cela, le procédé 100 peut prévoir la fourniture 101 d'une pluralité de structures de base 1A telles que celles décrites en relation avec les [Fig. 2a] et [Fig. 2b]. Chaque étape du procédé de fabrication 100 est avantageusement réalisée simultanément sur chaque structure de base 1A.

À l'étape de fourniture 101, la structure de base 1A peut être recouverte d'une couche de protection en matériau diélectrique, par exemple en dioxyde de silicium, qui est retirée, au moins partiellement, pour mener à bien l'ensemble des étapes du procédé de fabrication 100.

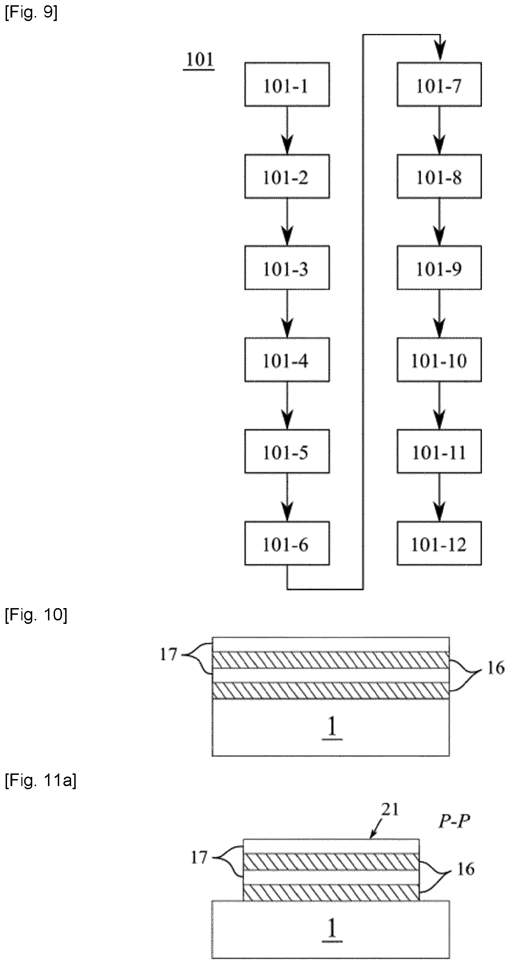

Un premier mode de mise en œuvre de l'étape de fourniture 101, représenté par le logigramme de la [Fig. 9], comprend la réalisation de la structure de base à partir d'un substrat nu. L'étape de fourniture 101 comprend une pluralité de sous-étapes 101 - 1 à 101-12. Les structures obtenues à l'issues de ces sous-étapes 101-1 à 101-12 sont représentées par les [Fig. 10] à [Fig. 20]. La structure de base 1A issue à l'issue de ce premier mode de réalisation de l'étape de fourniture 101 est avantageusement mise en œuvre dans la réalisation d'un transistor de type GAAFET.

Dans un premier temps, l'étape de fourniture comprend la formation, sur un substrat 1, d'une zone active 21, d'une grille sacrificielle 20 sur une portion de la zone active 21 et de premiers espaceurs latéraux 6 de part et d'autre de la grille sacrificielle 20.

Pour cela, une première sous-étape 101-1 comprend la formation, sur le substrat 1, d'un empilement de couches 16, 17, tel que représenté par la [Fig. 10]. La formation 101-1 dudit empilement peut être réalisée en pleine plaque ou sur une portion seulement du substrat 1. L'empilement comprend une alternance de couches de silicium-germanium 16 et de couches de silicium 17. L'alternance démarre, à partir du substrat 1, par une couche de silicium-germanium 16. La formation de l'empilement peut être réalisée par épitaxie.

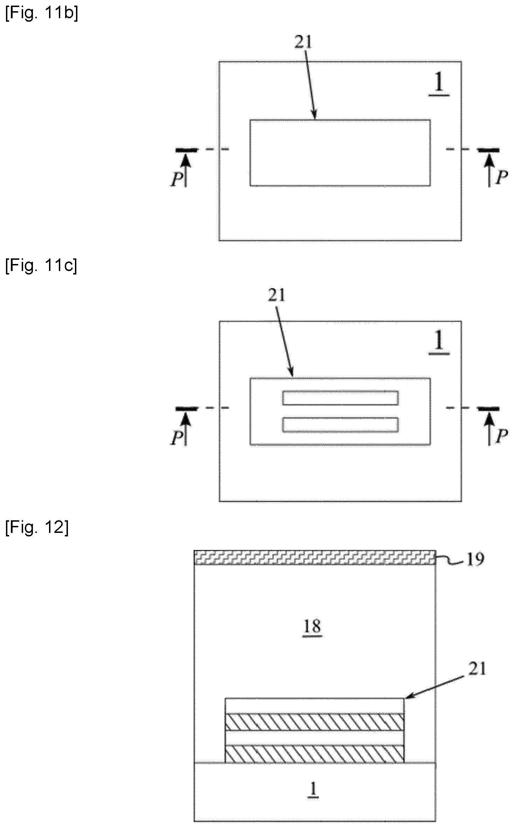

Une seconde sous-étape 101-2 comprend la délimitation d'une zone active 21 à partir de l'empilement de couches 16, 17 dont le résultat est illustré par les [Fig. 11a] à [Fig. 11c]. La gravure 101-2 est de préférence réalisée de manière à former des nano-feuilles, tel qu'illustrées en vue de dessus par la [Fig. 11b] ou des nano-fils, tel qu'illustrés en vue de dessus par la [Fig. 11c]. Par nano-fil, on entend une couche présentant une forme de fil. Un nano-fil s'étend préférentiellement parallèlement à la surface du substrat 1. Un nano-fil présente une épaisseur et une largeur inférieure à sa longueur et préférentiellement inférieures à 10 nm. L'épaisseur est mesurée perpendiculairement à la surface du substrat. La largeur est mesurée parallèlement à la surface du substrat 1 et perpendiculairement au plan de coupe P-P. La longueur est mesurée parallèlement à la surface du substrat 1 et parallèlement au plan de coupe P-P.

Une troisième sous-étape 101-3, illustrée par la [Fig. 12], comprend l'enrobage de la zone active 21 au moyen d'un matériau sacrificiel 18 sur lequel est ensuite déposé une couche de masque dur 19. Le matériau sacrificiel 18, par exemple du silicium polycristallin, est destiné à former une grille sacrificielle. La couche de masque dur 19 peut être en nitrure de silicium. Le matériau sacrificiel 18 recouvre la totalité de la zone active 21 et présente une épaisseur uniforme à partir du substrat 1. Cette épaisseur est supérieure ou égale à la hauteur de la structure de grille 2. L'épaisseur peut être ajustée par polissage mécanique et/ou chimique.

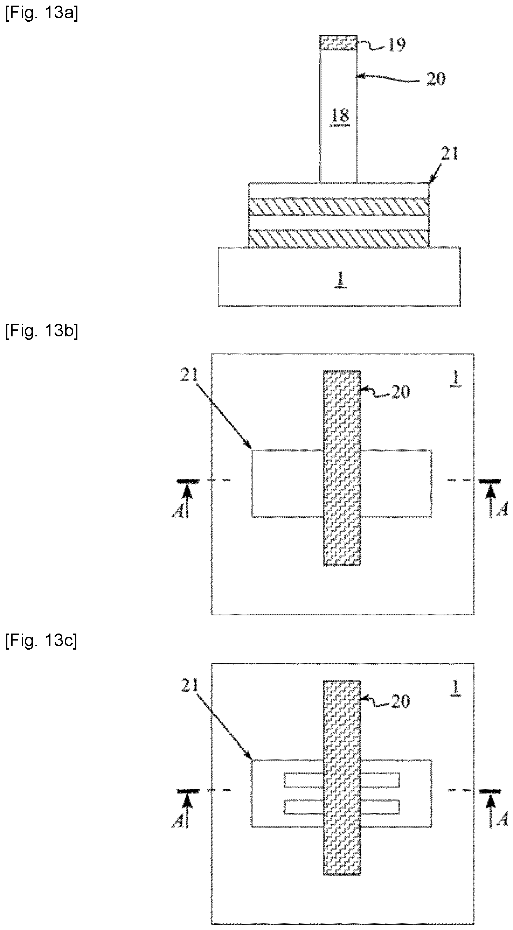

Une quatrième sous-étape 101-4 comprend la gravure sélective de la couche de masque dur 19 et du matériau sacrificiel 18 par rapport à la zone active 21, de manière à former une grille sacrificielle 20. La grille sacrificielle 20 est illustrée par les [Fig. 13a] à [Fig. 13c]. Les [Fig. 13b] et [Fig. 13c] représentent la zone active 21 et la grille sacrificielle 20 en vue de dessus. Dans l'exemple de la [Fig. 13b], la zone active 21 comprend des nano-feuilles dont une région est enrobée par la grille sacrificielle 20. Dans l'exemple de la [Fig. 13c], la zone active 21 comprend des nano-fils ayant chacun une région enrobée par la grille sacrificielle 20. La gravure sélective 101-4 est réalisée de sorte que la grille sacrificielle 20 enrobe une région de la zone active 21 dont une partie formera le canal du transistor final. La grille sacrificielle 20 présente de préférence des flancs verticaux (i.e. perpendiculaire au substrat 1) et un plateau.

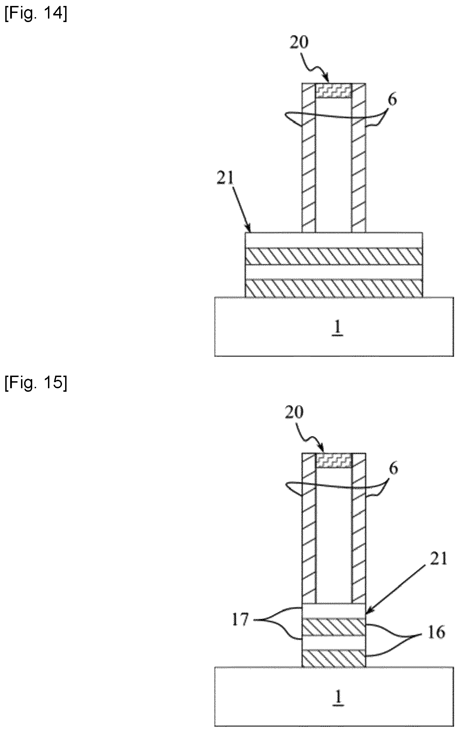

Une cinquième sous-étape 101-5, illustrée par la [Fig. 14], comprend la formation de premiers espaceurs latéraux 6 contre les flancs de la grille sacrificielle 20. Les premiers espaceurs latéraux 6, appelés également espaceurs externes, peuvent être réalisés dans le même matériau que le masque dur, par exemple en nitrure de silicium. Les espaceurs externes 6 peuvent être formés par dépôt conforme suivi d'une gravure anisotrope.

L'étape de fourniture de la structure de base comprend également la délimitation du canal 3 à partir de la zone active 21 en formant les flancs libres 3a du canal 3 à l'aplomb des premiers espaceurs latéraux 6.

Pour cela, une sixième sous-étape 101-6 comprend la gravure unidirectionnelle de la zone active 21 dont le résultat est illustré par la [Fig. 15]. La gravure unidirectionnelle 101-6 est réalisée de manière à retirer les parties de la zone active 21 qui ne sont pas recouvertes par la grille sacrificielle 20 ou les premiers espaceurs latéraux 6. De préférence, la couche isolante enterrée du substrat 1 de type SOI sert de couche d'arrêt de la gravure des nano-feuilles 16, 17. Cette sous-étape tend à relaxer les contraintes internes des nano-feuilles 16 en silicium-germanium, ce qui peut nuire à la mobilité des porteurs de charge. Toutefois, l'étape d'enrichissement du procédé de fabrication 100 permet de recouvrer la contrainte initiale, voire augmenter cette contrainte, permettant ainsi d'améliorer davantage la mobilité des porteurs

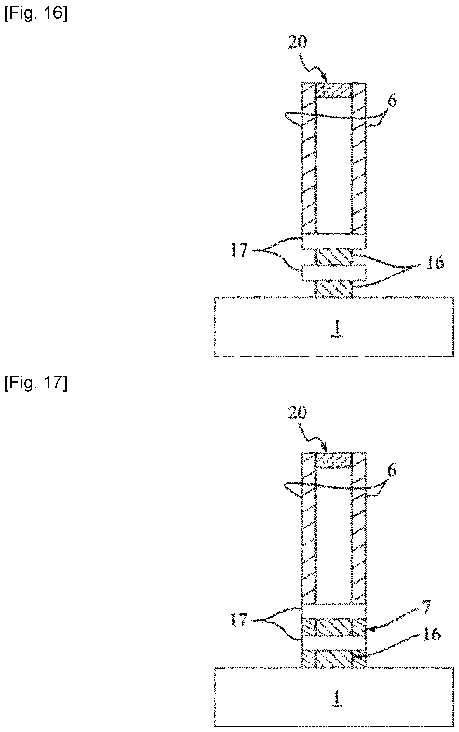

Une septième sous-étape 101-7 comprend la gravure des couches en silicium-germanium sélectivement par rapport aux nano-feuilles 17 en silicium. La gravure 101-7 est réalisée de manière à retirer une portion de chaque couche 16 en silicium-germanium, illustré par la [Fig. 16], de sorte que chaque extrémité des nano-feuilles 17 en silicium soit libre.

Une huitième sous-étape 101-8 comprend la formation de deuxièmes espaceurs latéraux 7, illustrés par la [Fig. 17]. Les deuxièmes espaceurs latéraux 7, dits espaceurs internes, viennent compenser le retrait du silicium-germanium des couches 16 en silicium-germanium. Ils peuvent être réalisés en nitrure de silicium.

L'étape de fourniture comprend également la formation de la structure de grille 2 en remplaçant la grille sacrificielle 20.

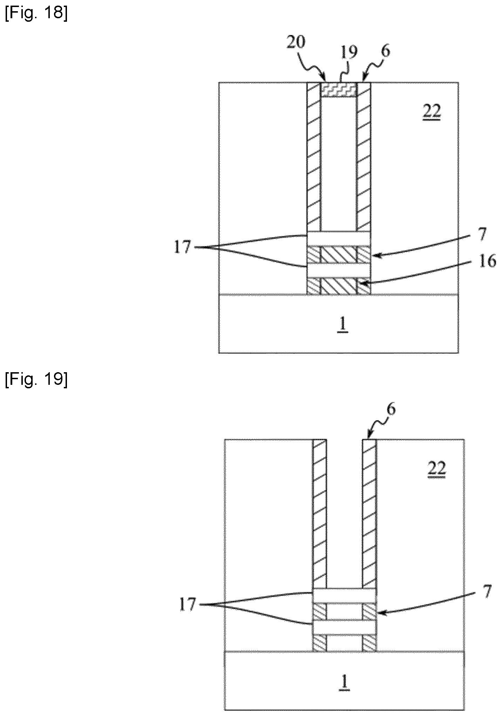

Pour cela, une neuvième sous-étape 101-9, illustré par la [Fig. 18], consiste à déposer une couche de matériau diélectrique 22 de manière à recouvrir la structure de la [Fig. 17]. Après polissage mécanique et/ou chimique, l'épaisseur de la couche de matériau diélectrique 22 est uniforme et atteint le sommet de la grille sacrificielle 20. Une surface supérieure de la grille sacrificielle 20 est libre.

Une dixième sous-étape 101-10, illustrée par la [Fig. 19], comprend la gravure de la couche de masque dur 19, de la grille sacrificielle 20 par rapport aux espaceurs externes 6 de manière à former une cavité délimitée par les espaceurs externes 6.

Préférentiellement, le formation de la structure de grille 2 comprend également le remplacement des couches en silicium-germanium 16 par un diélectrique de grille et une électrode de grille 9. Pour cela, la dixième sous-étape 101-10 comprend également la gravure des couches en silicium-germanium 16 sélectivement par rapport aux espaceurs internes 7 et aux nano-feuilles de silicium 17. Ainsi, à l'issue de la gravure 101-10, les nano-feuilles de silicium 17 sont en suspension au sein d'une cavité délimitée par les espaceurs latéraux externes et internes 6, 7.

La cavité formée à l'issue de l'étape 101-10 est remplie lors d'une onzième sous-étape 101-11 illustrée par la [Fig. 20]. L'étape 101-11 comprenant la formation d'un diélectrique de grille et d'une électrode de grille 9. Le diélectrique de grille, l'électrode de grille 9 et les espaceurs latéraux externes et internes 6, 7 forment ainsi la structure de grille 2. La structure de grille 2 peut avantageusement comprendre :
- un diélectrique de grille en matériau diélectrique à haute constante diélectrique, aussi appelé "high-k" en anglais, tel que qu'un oxyde d'hafnium, tapissant les surfaces de la cavité laissée par le retrait de la grille sacrificielle ;
- une couche de nitrure de titane déposée sur la couche de matériau high-k ;
- une électrode de grille 9 en tungstène, remplissant complètement la cavité ; et
- les espaceurs latéraux externes et internes 6, 7.

La structure de grille 2 ainsi formée enrobe chaque nano-feuille 17 et entoure préférentiellement complètement une portion centrale de chaque nano-feuille 17. La couche de matériau high-k et la couche de nitrure de titane peuvent être déposées par dépôt de couches atomiques (ou ALD pour "Atomic Layer Deposition" en anglais).

À l'issue de cette dernière sous-étape 101-11, la structure de base 1A telle que mise en œuvre dans le procédé de fabrication 100, est complète. Il est ensuite procédé un retrait partiel et sélectif 101-12 du matériau diélectrique 22 pour libérer la structure de base 1A.

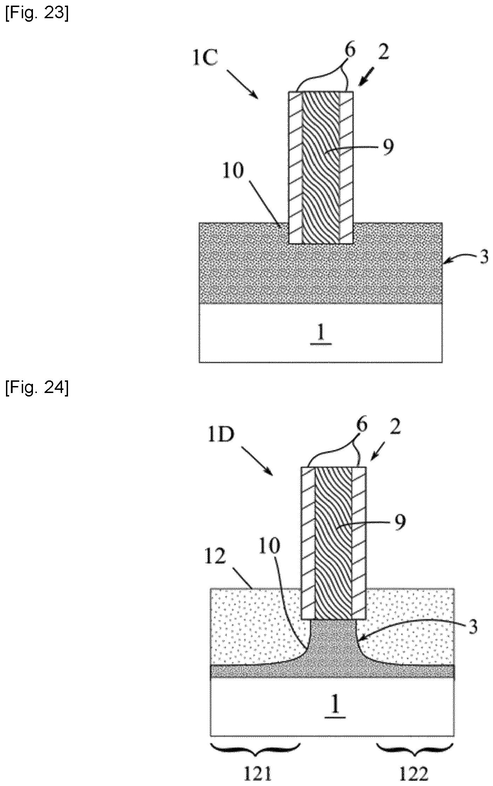

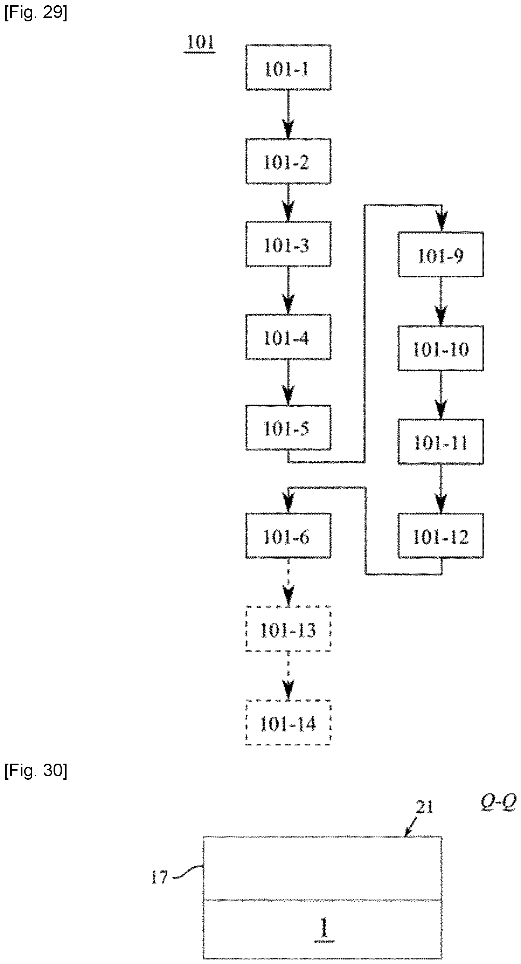

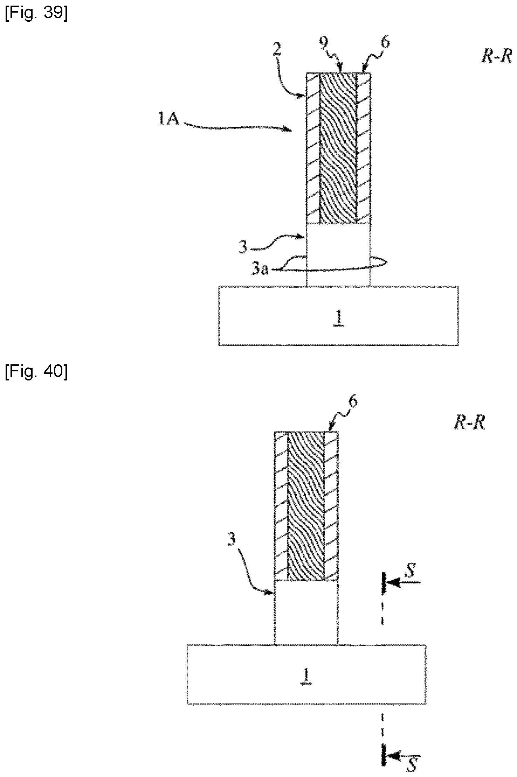

Le procédé de fabrication 100 s'applique également à la fabrication de transistors dits à ailettes, autrement appelés FinFET pour "Fin Field Effect Transistor". Les [Fig. 21a] à [Fig. 24] représentent un mode de réalisation des étapes du procédé de fabrication 100. Ce mode de réalisation diffère du mode de réalisation décrit précédemment en ce que l'étape de fourniture 101 de la structure de base 1A fournie une structure de base comprenant des ailettes. Les [Fig. 21a] et [Fig. 21b] représentent schématiquement un mode de réalisation de la structure de base 1A comprenant des ailettes. La mise en œuvre de l'étape de fourniture 101 permettant d'obtenir une structure de base 1A à ailettes est détaillée dans [Fig. 29] à [Fig. 39].

Les ailettes sont des couches semiconductrices appartenant au canal 3. Dans ce mode de réalisation, le canal 3 comprend deux ailettes 31, 32, c'est à dire deux couches semiconductrices orientées verticalement par rapport à la surface du substrat 1. Par ailette, on entend une couche présentant une largeur inférieure à son épaisseur et à sa longueur. L'épaisseur est mesurée perpendiculairement à la surface du substrat 1. La largeur est mesurée parallèlement au substrat 1 et perpendiculairement au plan de coupe N-N matérialisé dans la [Fig. 21b].La longueur est mesurée parallèlement au substrat 1 et au plan de coupe N-N.

Les ailettes sont de préférence parallèles entre elles. Chaque ailette semiconductrice 31, 32 est enrobée par la structure de grille 2. Cette structure de base 1A permet la fabrication de transistor à ailettes FinFET. Chaque ailette 31, 32 comprend, à ses extrémités, des surfaces libres formant les flancs 3a du canal 3, et sur lesquels sera déposée la couche réservoir 10 en silicium-germanium. Les [Fig. 22] et [Fig. 23] représentent les première et deuxièmes structures intermédiaires 1B, 1C obtenues à l'issue de l'étape 102 de croissance de la couche réservoir 10 sur les flancs 3a du canal 3 et de l'étape 103 d'enrichissement du canal 3 à partir des atomes de germanium de la couche réservoir 10. Les étapes 102, 103 de croissances et enrichissement du deuxième mode de mise en œuvre du procédé de fabrication 100 sont préférentiellement réalisées avec les mêmes conditions opératoires que le premier mode de mise en œuvre du procédé 100, détaillées précédemment en référence aux [Fig. 3] à [Fig. 6]. À la différence des [Fig. 3] à [Fig. 6], la croissance de la couche réserver 10 est réalisée de manière étendue et pas seulement au niveau du canal 3.

La [Fig. 24] représente le transistor pFET de type FinFET obtenu après gravure de la couche réservoir 10 et formation 104 des régions de drain et de source 121, 122 de part et d'autre du canal 3. La [Fig. 24] montre de manière plus réaliste l'effet de la gravure de la couche réservoir 10. En effet, un partie du canal 3 en silicium-germanium peut également être gravée. Toutefois La gravure est réalisée de sorte que le canal 3 soit toujours enrobé par la structure de grille 2, ses flancs restant à l'aplomb des espaceurs latéraux 6.

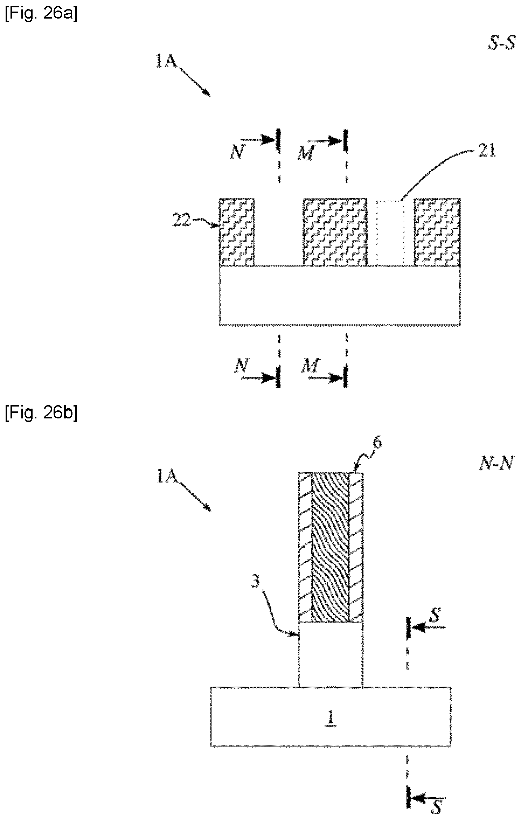

Une variante de la structure de base 1A fournie par l'étape de fourniture 101 est illustrée par les [Fig. 26a] et [Fig. 26b]. Cette variante comprend des plots 22 disposés de part et d'autre du canal 3 et de la structure de grille 2. Les plots 22 sont représentés selon un plan de coupe S-S dans la [Fig. 26a], le plan de coupe S-S étant matérialisé dans la [Fig. 26b]. Les plots 22 sont positionnés entre chaque ailette 31, 32. Les plots 22 forment ainsi des barrières entre les ailettes 31, 32 facilitant la formation de portions de la couche réservoir 10. Les barrières formées limitent la coalescence des portions de couche réservoir 10 lors de leur formation 102.

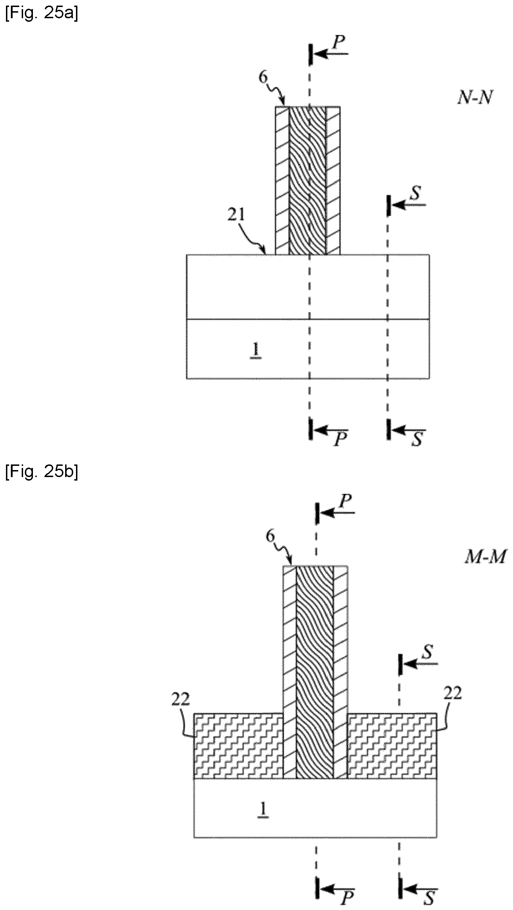

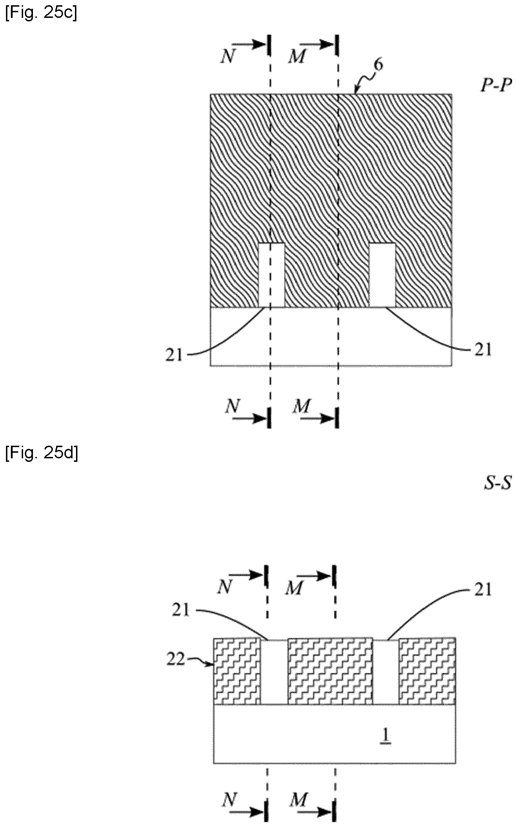

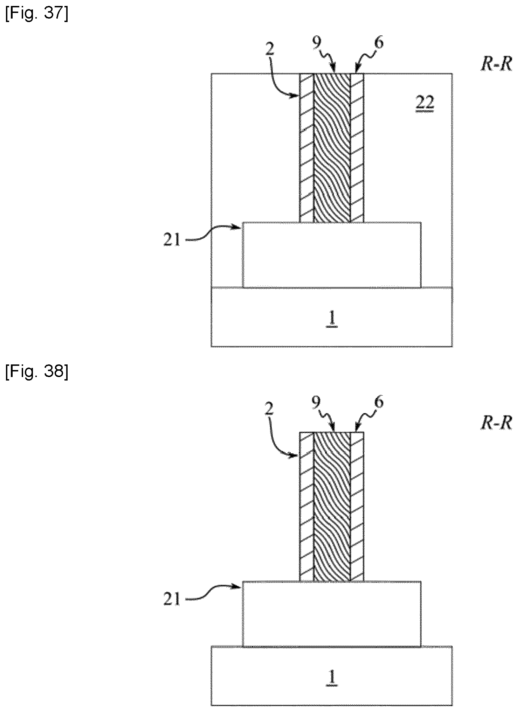

Les plots 22 sont avantageusement déposés avant la délimitation du canal de la structure de base. La structure, illustrée par les [Fig. 25a] à [Fig. 25d] comprend alors des ailettes 21 s'étendant au-delà de la structure de grille 2. Les plots 22 sont déposés entre chaque ailette 21, tel qu'illustré par la [Fig. 25d]. À l'issue d'une étape de délimitation décrite en référence à la [Fig. 38], les ailettes 21 gravées afin d'obtenir chaque canal 3. Les [Fig. 26a] et [Fig. 26b] représentent schématiquement, selon deux plans de coupe S-S, N-N, un canal 3 et les plots 22. La [Fig. 25a] matérialise d'ailleurs en pointillés l'emplacement d'une ailette avant la délimitation du canal 3. La délimitation du canal 3 peut comprendre une gravure du silicium non protégé par la structure de grille 2 pouvant également graver une partie des plots 22.

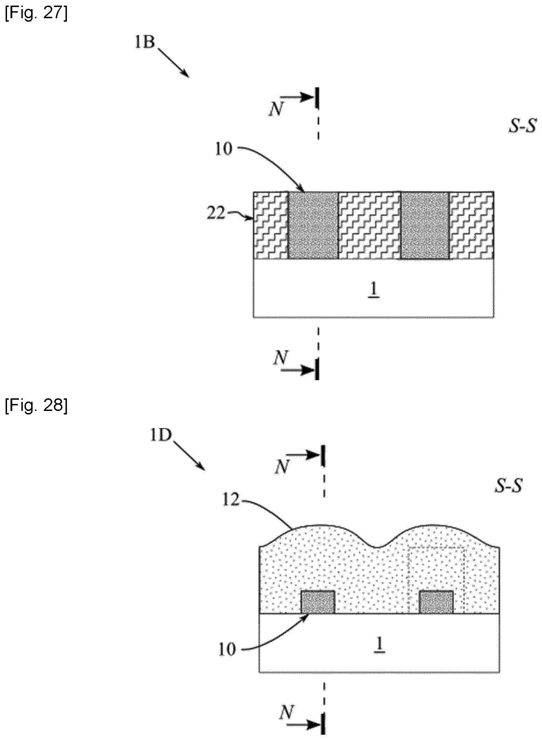

La [Fig. 27] illustre un exemple d'une couche réservoir 10 issue de l'étape 102 comprenant deux portions, chaque portion étant localisée entre deux plots 22, au niveau d'une ailette. Avant la formation des régions de drain et de source, les plots 22 peuvent être retirés. La [Fig. 28] illustre un exemple d'une couche 12 en SiGe dopé destinée à former une région de drain ou de source comprenant deux portions, chacune des portions étant formée 104 au niveau de chaque portion de couche réservoir 10. Les plots 22 ayant été préalablement retirés, les portions de la couche 12 en SiGe dopé peuvent coalescer. La [Fig. 28] montre, de la même manière que la [Fig. 24], une partie de chaque couche réservoir 10 restante après gravure partielle de ces dites couches 10.

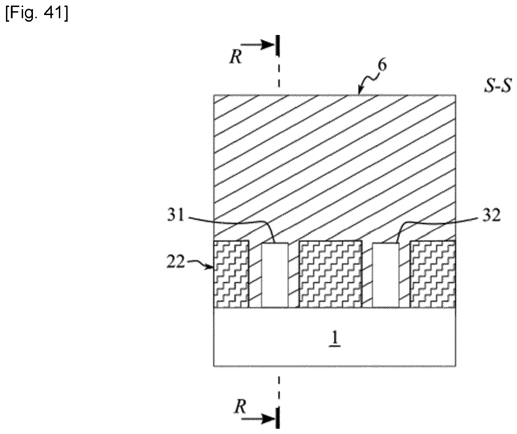

Un deuxième mode de mise en œuvre de l'étape de fourniture 101, permettant d'obtenir la structure de base 1A illustrée en [Fig. 21a] et [Fig. 21b], est représenté par le logigramme de la [Fig. 29]. Les premier et deuxième mode de réalisation de l'étape de fourniture 101 comprennent des sous-étapes communes qui présentent les mêmes signes de référence dans les [Fig. 9] et [Fig. 29]. Les structures obtenues à l'issues de chaque sous-étape sont représentées par les [Fig. 30] à [Fig. 41]. Les différences par rapport au premier mode de réalisation de l'étape de fourniture 101 sont présentées ci-après.

Selon ce deuxième mode de réalisation, la sous-étape 101-1 de l'étape de fourniture 101 comprend la formation, sur le substrat 1, d'une couche de silicium 17, tel que représenté par la [Fig. 30]. À la différence du premier mode de réalisation de l'étape de fourniture 101 (cf. [Fig. 10]), il n'y a qu'une seule couche de silicium déposée au lieu d'un empilement de couches.

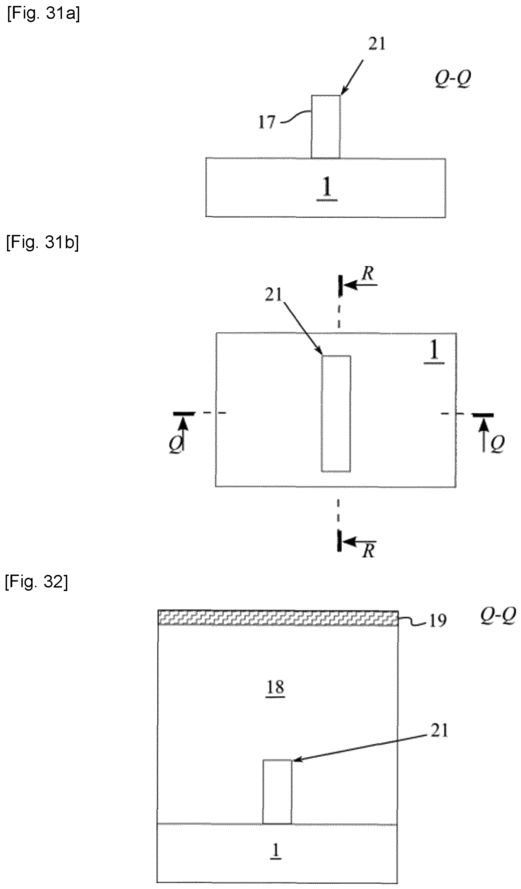

La sous-étape 101-2, illustrée par les [Fig. 31a] et [Fig. 31b] comprend la délimitation de la zone active 21 du futur transistor. En revanche, à la différence du premier mode de réalisation, la zone active 21 comprend au moins une ailette, tel qu'illustrée en vue de dessus par la [Fig. 31b].

La sous-étape 101-3, illustrée par la [Fig. 32], comprend l'enrobage de l'ailette 21 au moyen d'un matériau sacrificiel 18 sur lequel est ensuite déposé une couche de masque dur 19.

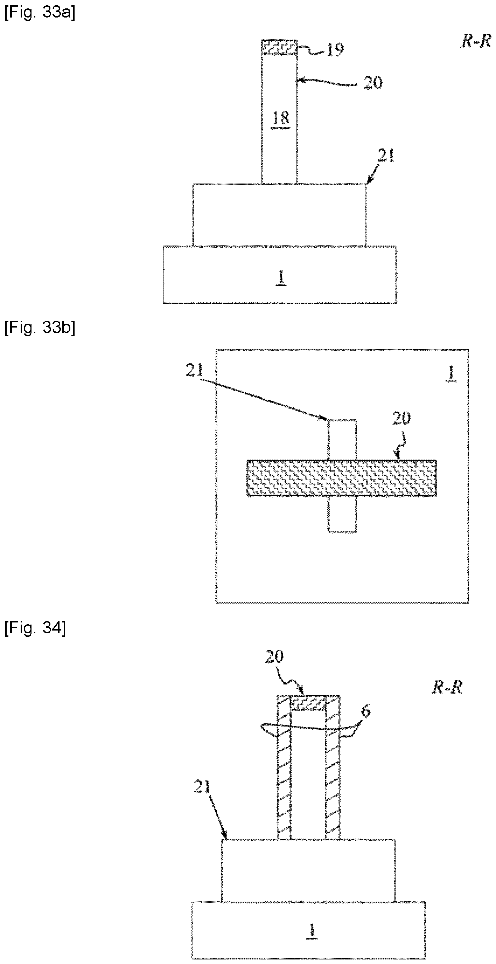

La sous-étape 101-4, illustrée par les [Fig. 33a] et [Fig. 33b], comprend la gravure sélective de la couche de masque dur 19 et du matériau sacrificiel 18 de manière à former une grille sacrificielle 20. La grille sacrificielle 20 enrobe une région de l'ailette 21 dont une partie formera le canal du transistor final.

La sous-étape 101-5, illustrée par la [Fig. 34], comprend la formation d'espaceurs latéraux externes 6 contre les flancs de la grille sacrificielle 20. À la différence du premier mode de réalisation de l'étape de fourniture 101, ce deuxième mode de réalisation ne prévoit que la formation des espaceurs latéraux externes 6 et non la formation d'espaceurs internes (signe de référence 7 sur les [Fig. 17] à [Fig. 20]).

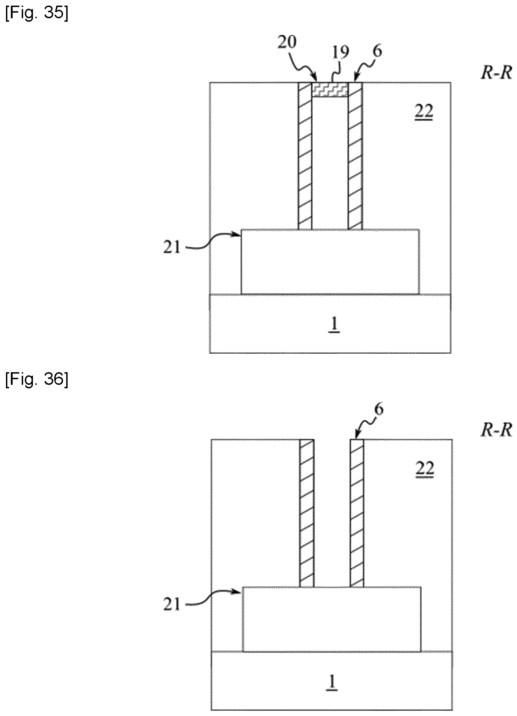

La sous-étape 101-9, illustrée par la [Fig. 35], consiste également à déposer une couche de matériau diélectrique 22 de manière à recouvrir la structure de la [Fig. 34] de telle manière que l'épaisseur de la couche de matériau diélectrique 22 soit uniforme et atteigne le sommet de la grille sacrificielle 20.

La sous-étape 101-10, illustrée par la [Fig. 36], comprend la gravure de la couche de masque dur 19 et de la grille sacrificielle 20 réalisée sélectivement par rapport aux espaceurs latéraux 6 et à l'ailette 21. Ainsi, à l'issue de la sous-étape 101-10 de gravure, une portion de l'ailette 21 est exposée au sein d'une cavité délimitée par les espaceurs latéraux 6.

La cavité délimitée par les espaceurs latéraux 6 est remplie lors de la sous-étape 101-11, illustrée par la [Fig. 37], afin de former un diélectrique de grille (nonreprésentée sur les figures) et une électrode de grille 9. Le diélectrique de grille, l'électrode de grille 9 et les espaceurs latéraux 6 forment ainsi la structure de grille 2. La structure de grille 2 ainsi formée enrobe une portion de l'ailette 21 qui correspond au canal.

À l'issue de la sous-étape 101-11 de remplissage, la sous-étape 101-12 de retrait sélectif du deuxième matériau diélectrique 22, illustré par la [Fig. 38], est réalisé pour libérer la structure de grille 2 et l'ailette 21.

Le premier mode de réalisation de l'étape de fourniture peut comprend avantageusement la délimitation du canal avant de former la structure de grille définitive. À l'inverse, ce deuxième mode de réalisation de l'étape de fourniture réalise avantageusement la délimitation du canal après la formation de la structure de grille. Pour cela, la sous-étape 101-6 comprend la gravure unidirectionnelle, illustrée par la [Fig. 39], d'une partie de l'ailette 21 non-protégée par la structure de grille 2. La sous-étape de gravure unidirectionnelle 101-6 permet ainsi de former le canal 3, enrobé par la structure de grille 2. La sous-étape 101-6 de gravure permet également de libérer les flancs 3a du canal 3, à l'aplomb de chaque espaceur latéral 6.

La structure de base 1A est obtenue à l'issue de cette dernière sous-étape 101-6 est avantageusement mise en œuvre dans la fabrication d'un transistor de type FinFET.

Ce deuxième mode de réalisation de l'étape de fourniture comprend avantageusement une sous-étape 101-13 complémentaire, de formation des plots 22, illustrés par la [Fig. 40]. Les plots 22 sont formés de part et d'autre du canal 3 et préférentiellement d'une portion basse de la structure de grille 2. Les plots 22 sont représentés selon un plan de coupe S-S dans la [Fig. 41]. Les plots 22 sont préférentiellement réalisés en matériau diélectrique. Les plots 22 sont positionnés entre chaque ailette 31, 32. La hauteur des plots 22 à partir du substrat 1, c'est-à-dire perpendiculairement au substrat 1, est supérieure ou égale à la hauteur du canal 3 à partir du substrat 1.

L'invention trouve un intérêt particulier dans la cointégration de transistors de types pFET et nFET sur un même substrat. Par cointégration, on entend la fabrication de transistors de types différents par un même procédé et sur un même substrat.

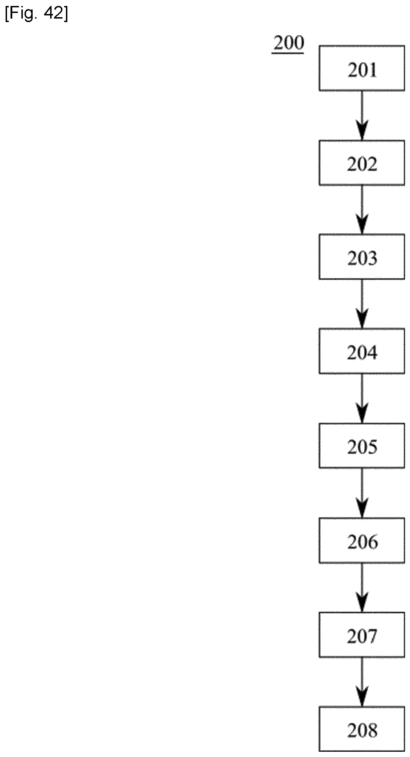

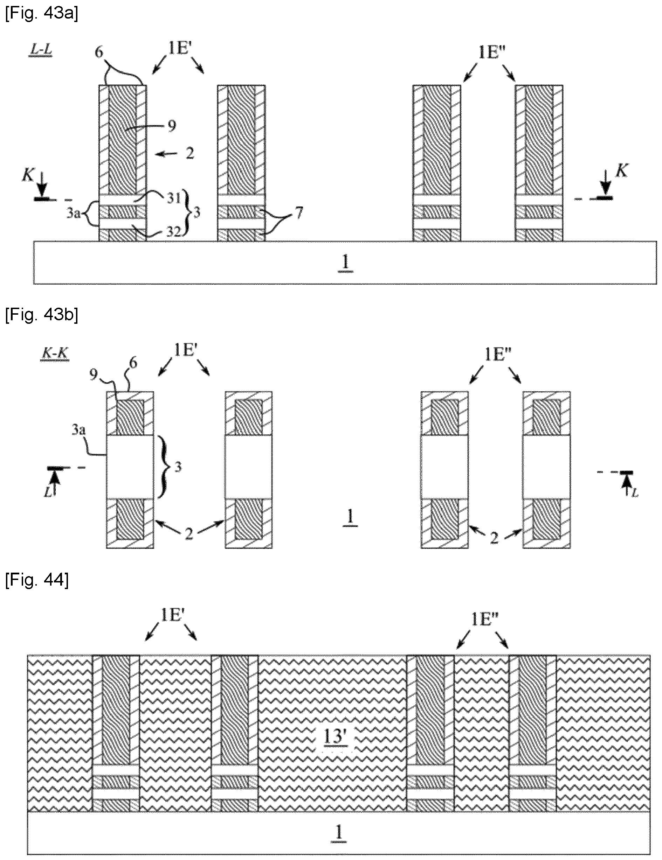

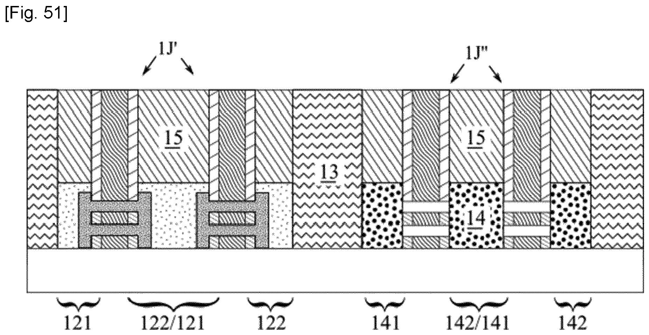

La [Fig. 42] représente un logigramme de mise en œuvre d'un procédé de cointégration 200 d'un transistor de type pFET et d'un transistor de type nFET sur un même substrat. Les [Fig. 43a] à [Fig. 51] représentent schématiquement des structures de base et des structures intermédiaires obtenues à l'issue des étapes du procédé de cointégration 200. Ces figures représentent notamment les structures intermédiaires lors de la cointégration des quatre transistors, soit deux transistors de type pFET et deux transistors de types nFET.

Une première étape 201 du procédé de cointégration 200 comprend la fourniture 201 de structures de base 1E', 1E" à partir desquels seront réalisés les transistors pFET et nFET. À l'inverse de l'étape de fourniture pour la réalisation d'un seul transistor, l'étape de fourniture 201 du procédé de cointégration 200 prévoit au moins une structure de base 1E', 1E" pour chaque type de transistor. Dans les exemples illustrés par les [Fig. 43a] et [Fig. 43b], quatre structures de base 1E', 1E" identiques sont fournies. Deux premières structures de base 1E' à partir desquelles seront réalisés deux transistors pFET, et deux deuxièmes structures de base 1E" à partir desquelles seront réalisés deux transistors nFET. Chaque structure de base 1E', 1E" comprend les caractéristiques décrites en référence aux [Fig. 2a] et [Fig. 2b], c'est à dire :
- un canal 3 en silicium ; et
- une structure de grille 2, enrobant le canal 3 en laissant libre deux flancs 3a libres.

Dans cet exemple, les structures de base 1E', 1E" sont avantageusement destinées à former des transistors GAAFET car elles comportent des nano-feuilles 31, 32 de silicium. Le procédé de cointégration 200 est également applicable à la fabrication de transistors FinFET, auquel cas il est avantageux de fournir des structures de base 1E', 1E" tel que décrit précédemment en référence aux [Fig. 21a] et [Fig. 21b].

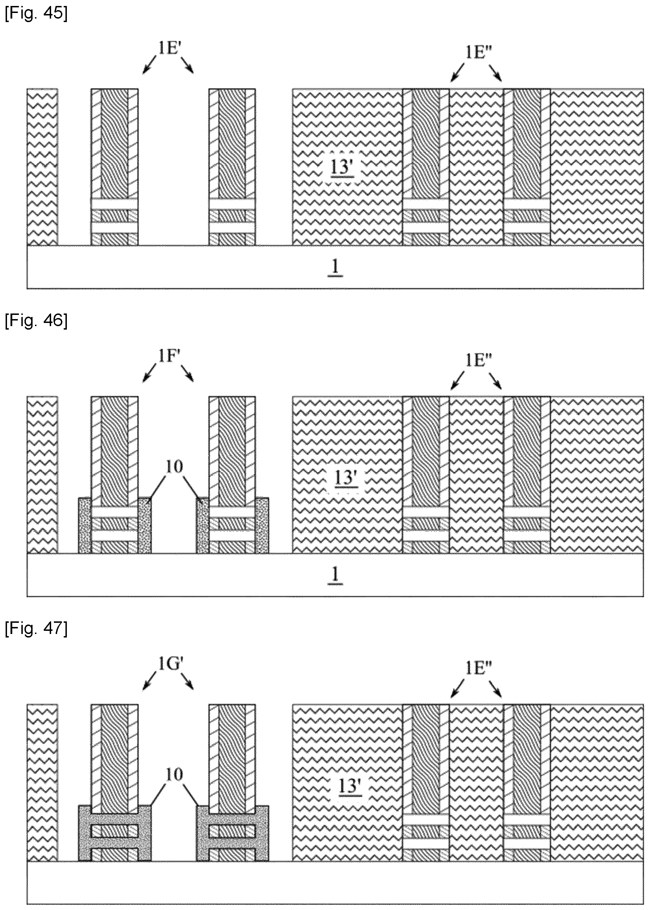

Afin de réaliser les étapes suivantes sur les premières structures de base 1E', il est avantageux de réaliser une étape 202 de protection des deuxièmes structures de base 1E" au moyen d'une première couche protectrice 13' recouvrant intégralement les deuxièmes structures de base 1E", tel qu'illustré par la [Fig. 45]. La couche première protectrice 13' peut être déposée en pleine plaque, comme illustré par la [Fig. 44], dans un premier temps puis retirée localement autour des premières structures de base 1E' dans un second temps afin de permettre l'exécution des étapes suivantes. La première couche protectrice 13' peut être un matériau diélectrique tel le dioxyde de silicium. Une gravure de la première couche protectrice 13' autour des premières structures de base 1E' permet de fabriquer les transistors pFET sans compromettre la réalisation ultérieure des transistors nFET.

Le procédé de cointégration 200 comprend séquentiellement, sur chaque première structure de base 1E', une étape 203 de croissance d'une première couche, une étape 204 d'enrichissement et une étape 205 de formation des régions de drain et de source, similaires aux étapes 102, 103, 104 du procédé de fabrication 100 décrites précédemment en référence aux [Fig. 1] et [Fig. 3] à [Fig. 7]. Ainsi, les paramètres opératoires du procédé de fabrication 100 peuvent être transposés aux étapes 203, 204, 205.

La [Fig. 46] représente une première structure intermédiaire 1F' obtenue à l'issue de l'étape 203 de croissance au cours de laquelle une couche réservoir 10 en alliage de silicium-germanium croît sur les flancs 3a du canal 3 de chaque première structure de base 1E'.

La [Fig. 47] représente une deuxième structure intermédiaire 1G', obtenue à l'issue de l'étape 204 d'enrichissement du canal 3.

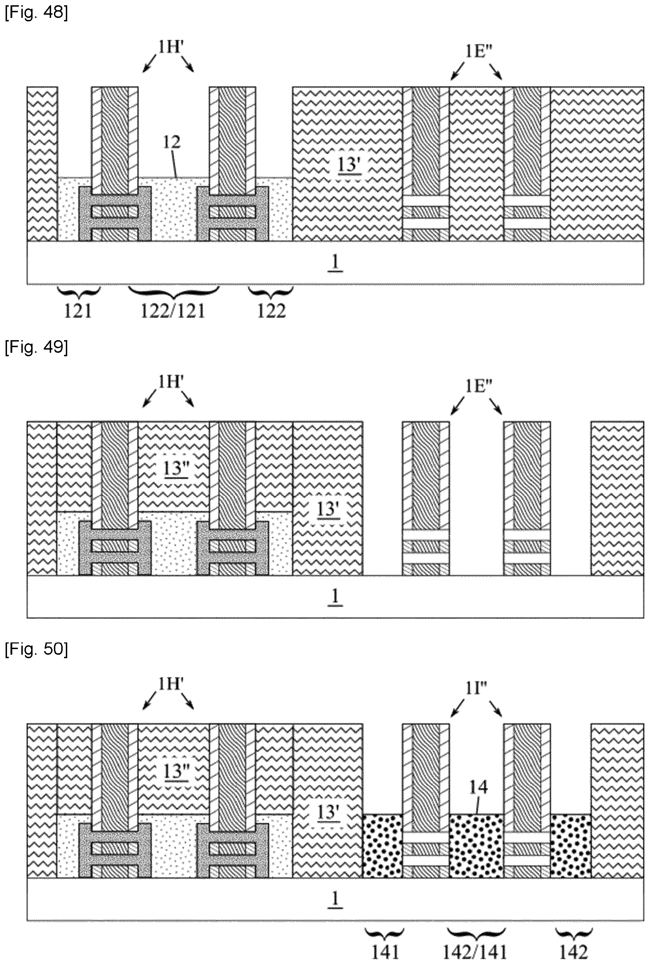

La [Fig. 48] représente deux premiers transistors 1H' de type pFET, obtenues à l'issue de l'étape 205 de formation d'une première région de drain et d'une première région de source de part d'autre de chaque canal 3 en silicium-germanium. Dans cet exemple, les deux premiers transistors 1H' produits comprennent une région drain/source 122/121 commune.

Afin de protéger les premiers transistors 1H' de type pFET lors de la réalisation des transistors de type nFET, il est avantageux de réaliser une étape 206 de protection des premiers transistors 1H' au moyen d'une deuxième couche protectrice 13" déposée au niveau desdits premiers transistors 1H' et de manière à les recouvrir intégralement, tel qu'illustré par la [Fig. 49]. L'étape 206 de protection des premiers transistors 1H' laisse avantageusement les deuxièmes structures de base 1E" libres de manière à pouvoir réaliser les étapes suivantes. Pour cela, l'étape 206 de protection des premiers transistors 1H' comprend avantageusement une gravure de la première couche protectrice 13' localisée autour des deuxièmes structures de base 1E", illustrée par la [Fig. 49].

La [Fig. 50] représente des deuxièmes transistors 1I" obtenue à l'issue d'une étape 207 de formation de deuxièmes régions de drain 141 et de source 142 de part d'autre de chaque canal 3 des deuxièmes structures de base 1E". Les deuxièmes régions de drain et de source 141, 142 sont en matériau semiconducteur dopé n, tel que du silicium dopé au phosphore. Dans cet exemple, les deux deuxièmes transistors 1H" produits comprennent une région drain/source 142/141 commune.

La cointégration 200 des transistors 1I', 1I" peut avantageusement être complété par une étape 208, illustrée par la [Fig. 51], de formation des électrodes métalliques 15. Les électrodes métalliques 15 sont déposées et connectées aux premières et deuxièmes régions de drain et de source 121, 122, 141, 142. Les électrodes métalliques 15 peuvent être en tungstène.

## Revendications

1. Procédé de fabrication (100) d'un transistor (1D) pFET, le procédé de fabrication (100) du transistor (1D) comprenant les étapes suivantes :
- la fourniture (101) d'une structure de base (1A) comprenant un canal (3) en silicium et une structure de grille (2), la structure de grille (2) comprenant une électrode de grille (9), un diélectrique de grille et des espaceurs latéraux (6, 7), le diélectrique de grille séparant l'électrode de grille (9) du canal (3), les espaceurs latéraux (6, 7) étant disposés de part et d'autre de la structure de grille (2), la structure de grille (2) enrobant le canal (3) en laissant libre deux flancs (3a) du canal (3) à l'aplomb des espaceurs latéraux (6, 7) de la structure de grille (9) ;
- la croissance (102) d'une première couche (10) en alliage de silicium-germanium sur les flancs (3a) du canal (3) ;
- l'enrichissement (103) du canal (3) avec des atomes de germanium de la première couche (10) ; et
- la formation (104) d'une région de drain (121) et d'une région de source (122) de part et d'autre du canal (3).

2. Procédé de fabrication (100) selon la revendication précédente, dans lequel le canal (3) de la structure de base (1A) comprend au moins une nano-feuille en silicium ou au moins un nano-fil en silicium ou au moins une ailette en silicium (31, 32).

3. Procédé de fabrication (100) selon l'une des revendications précédentes, dans lequel le canal (3) de la structure de base (1A) comprend une pluralité d'ailettes en silicium (31, 32) parallèles entre elles et dans lequel la structure de base (1A) comprend des plots (22) en matériau diélectrique disposés de part et d'autre du canal (3) entre chaque ailette en silicium (31, 32).

4. Procédé de fabrication (100) selon la revendication précédente, comprenant le retrait des plots (22) après l'enrichissement (103) du canal.

5. Procédé de fabrication (100) selon l'une des trois revendications précédentes, dans lequel la croissance (102) de la première couche (10) en alliage de silicium-germanium est amorcée à partir des flancs de chaque nano-feuille en silicium ou à partir des flancs de chaque nano-fil en silicium ou à partir des flancs de chaque ailette en silicium.

6. Procédé de fabrication (100) selon l'une des revendications précédentes, dans lequel l'enrichissement (103) est réalisé par application d'un recuit de diffusion configuré pour faire diffuser des atomes de germanium de la première couche (10) dans le canal (3).

7. Procédé de fabrication (100) selon l'une des revendications précédentes, dans lequel l'enrichissement (103) est réalisé par oxydation de la première couche (10) configurée pour faire condenser des atomes de germanium de la première couche (10) dans le canal (3).

8. Procédé de fabrication (100) selon l'une des revendications précédentes, dans lequel la formation (104) des régions de drain (121) et de source (122) est réalisée par la formation d'une deuxième couche (12) sur la première couche (10) de part et d'autre du canal (3), la formation (104) de la deuxième couche (12) étant configurée pour appliquer une contrainte de compression sur le canal (3).

9. Procédé de fabrication (100) selon l'une des revendications précédentes, dans lequel la fourniture (101) de la structure de base (1A) comprend :
- la formation (101-1 à 101-5), sur un substrat (1), d'une zone active (21), d'une grille sacrificielle (20) sur une portion de la zone active (21) et de premiers espaceurs latéraux (6) de part et d'autre de la grille sacrificielle (20) ;
- la délimitation (101-6 à 101-8) du canal (3) à partir de la zone active (21) en formant les flancs (3a) libres du canal (3) à l'aplomb des premiers espaceurs latéraux (6) ;
- la formation (101-9 à 101-12) de la structure de grille (2) en remplacement de la grille sacrificielle (20).

10. Procédé de fabrication (100) selon la revendication précédente, dans lequel la zone active (21) comprend un empilement de couches (16, 17) comprenant au moins une couche de silicium-germanium (16) et au moins une couche de silicium (17) en alternance, l'empilement de couches (16, 17) commençant, à partir du substrat (1), par une couche de silicium-germanium (16).

11. Procédé de fabrication (100) selon la revendication précédente, dans lequel la formation (101-9 à 101-12) de la structure de grille comprend un remplacement de ladite au moins une couche de silicium-germanium par un diélectrique de grille et une électrode de grille (9).

12. Procédé de cointégration (200) d'un premier transistor (1H') pFET et un deuxième transistor (1H") nFET, le procédé de cointégration (200) comprenant les étapes suivantes :
- la fourniture (201) d'une première structure de base (1E') et d'une deuxième structure de base (1E") identique à la première structure de base (1E'), chaque structure de base (1E') comprenant un canal (3) en silicium et une structure de grille (2), la structure de grille (2) enrobant le canal (3) en laissant libre deux flancs (3a) du canal (3) ;
- sur la première structure de base (1E') :
- la croissance (203) d'une première couche (10) en alliage de silicium-germanium sur les flancs (3a) du canal (3) ;
- l'enrichissement (204) du canal (3) avec des atomes de germanium de la première couche (10) ;
- la formation (205) d'une première région de drain (121) et d'une première région de source (122) de part d'autre du canal (3) ; et
- sur la deuxième structure de base (1E"), la formation (207) d'une deuxième région de drain (141) et d'une deuxième région de source (142) de part d'autre du canal (3).

13. Procédé de cointégration (200) selon la revendication précédente, comprenant, avant l'étape de croissance (203) appliquée à la première structure de base (1E'), la protection (202) de la deuxième structure de base (1E") au moyen d'une première couche protectrice (13').

14. Procédé de cointégration (200) selon la revendication précédente, comprenant, avant l'étape de formation (207) appliquée à la deuxième structure de base (1E"), la libération de la deuxième structure de base (1E") en retirant la première couche protectrice (13').

15. Procédé de cointégration (200) selon l'une des trois revendications précédentes, comprenant, avant l'étape de formation (207) appliquée à la deuxième structure de base (1E"), la protection du premier transistor pFET au moyen d'une deuxième couche protectrice (13").
